# EUROPEAN PATENT APPLICATION

(11) **EP 0 681 423 A1**
(43) Date of publication of application: **08.11.1995**
(21) Application number: 95106849.3
(22) Date of filing: 05.05.1995
(51) Int. Cl.: H05K 9/00, H05K 13/00, B65D 65/40

(54) **Electrostatic sensitive component package**

(30) Priority: 06.05.1994 US 239388; 05.04.1995 US 417243
(71) Applicant: Adelman, Herbert B., Hockessin, Delaware 19707 (US)
(72) Inventor: Adelman, Herbert B., Hockessin, Delaware 19707 (US)
(74) Representative: Wagner, Karl H., Dipl.-Ing.

(57) **Abstract**

An electrostatic sensitive component package includes upper and lower layers of metallized plastic with an intermediate layer of an anti-stat support member such electrically conductive foam. An electrostatic sensitive component such as an integrated circuit is mounted against the foam. The metallized plastic layers and the foam are secured together by an ultrasonic seal to form a Faraday cage around the component and thus prevent electrostatic forces from reaching the component to thereby form an anti-stat package for the component. The resulting package may have an open side which is closed by an integral flap.

## Description

### Background of the Invention

Techniques have been employed for packaging electrostatic sensitive parts such as integrated circuits. Ideally, such packaging should be done with the use of automatic equipment. U.S. Patent No. 4,790,433 describes a packaging combination which includes upper and lower layers of metallized plastic with the integrated circuit mounted on an electrically conductive foam between the layers. The pins of the circuit are embedded in the foam to hold the integrated circuit in place. Prior to mounting the integrated circuit on the foam the foam face is coated with a primer and then with an anti-stat coating. The foam is laminated to the upper and lower layers by, for example, a hot melt pressure-sensitive adhesive.

One of the concerns with forming a package in the manner described in U.S. Patent No. 4,790,433 is the danger that electrostatic forces or electromagnetic fields such as from sonar, motors, radar, etc. might work their way through the adhesive securement and reach the electrostatic sensitive component (integrated circuit). A further concern is that it is not always possible to obtain relatively thick carbonized open cell polyurethane rolls (the preferred foam) long enough to be processed on coating and laminating machines. Difficulties are also sometimes encountered in laminating the metallized film to the open cell foam.

U.S. Patent Nos. 4,156,751 and 4,424,900 disclose prior art attempts at forming anti-stat packages wherein the sides of the package are heat sealed together. These patents, however, do not relate to automated packaging techniques.

### Summary of the Invention

An object of this invention is to provide an electrostatic sensitive component package which meets the above needs.

A further object of this invention is to provide a packaging assembly and method of manufacture which could be used for forming such package.

A still further object of this invention is to provide techniques for the automated forming of anti-stat packages.

In accordance with this invention, a package of the type disclosed in U.S. Patent No. 4,790,433 is formed by securing the foam to the upper and lower metallized plastic layers by an ultrasonic seal rather than an adhesive. The seal may form a completely closed peripheral seal around the component to thereby result in a Faraday cage around the component for preventing electrostatic forces from reaching the component. Thus an anti-stat package results.

A Faraday cage may also be formed by ultrasonic sealing where the package is in pouch form having an open side closed by a flap. The ultrasonic sealing may be formed along the three remaining edges of the pouch or along the two side edges where the pouch is formed by folding a single plastic layer upon itself.

In the preferred practice of this invention the electrostatic sensitive component is an integrated circuit which is mounted on a carbonized open cell polyurethane foam. The upper and lower layers of the package are preferably metallized polyester.

### The Drawings

Figure 1 is a perspective view of an electrostatic sensitive component package in accordance with this invention;
Figure 2 is a side elevational view of the package shown in Figure 1;
Figure 3 is an end elevational view of the package shown in Figures 1-2;
Figure 4 is a top plan view partially broken away showing the various layers of a package of this invention before being assembled;
Figure 5 is a cross-sectional view taken through Figure 4 along the line 5-5;
Figure 6 is a cross-sectional view showing a step in the formation of the package of Figures 4-5;
Figure 7 is a perspective view showing the sequence of assembly for packages in accordance with this invention;
Figure 8 is a perspective view similar to Figure 7 shown in alternative sequence of assembly for packages in accordance with this invention;
Figure 9 is a perspective view of a package in accordance with this invention;
Figure 10 is an exploded view of the components for forming yet another package in accordance with this invention;
Figure 11 is a perspective view of still yet another package in accordance with this invention;
Figure 12 is a view similar to Figure 7 showing the assembly of a pouch form of package in accordance with a further embodiment of this invention;
Figure 13 is a perspective view of the pouch formed by the assembly of Figure 12 wherein the flap of the pouch is in an open position;
Figure 14 is a top plan view of the pouch shown in Figure 13 with the flap in a closed tucked in position;
Figure 15 is a view similar to Figure 12 of yet another form of this invention for forming an alternative pouch;
Figure 16 is a perspective view of the pouch formed by the assembly of Figure 15 with the flap in an open position; and
Figure 17 is a top plan view of the pouch shown in Figure 16 with the flap in its closed tucked in position.

### Detailed Description

The present invention is intended to provide improved variations of the type of package disclosed in U.S. Patent No. 4,790,433. The details of that patent are incorporated herein by reference thereto and thus a description of various materials, dimensions, etc. will not be repeated except as is necessary for an understanding of the present invention.

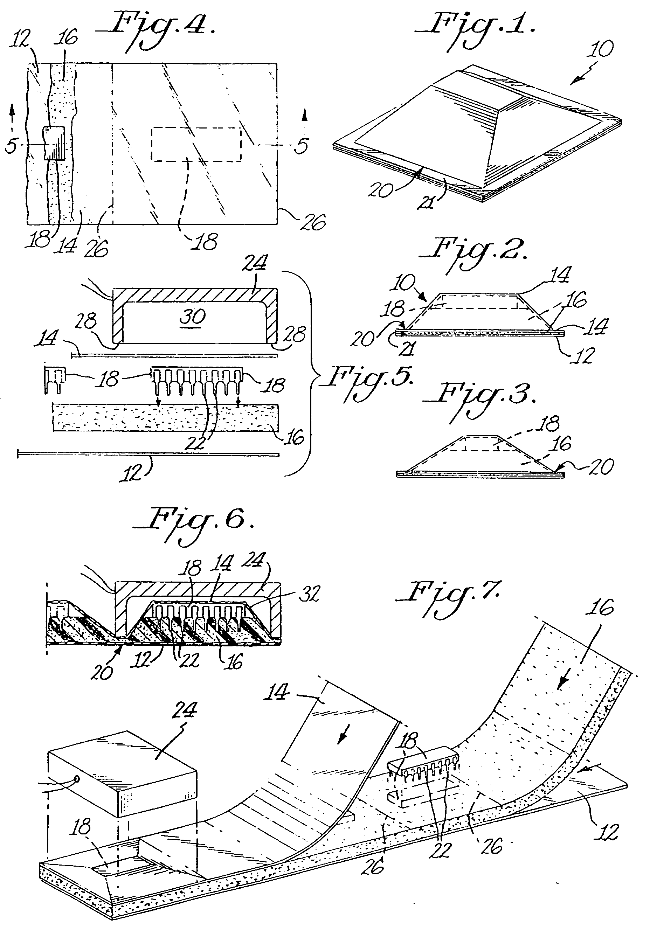

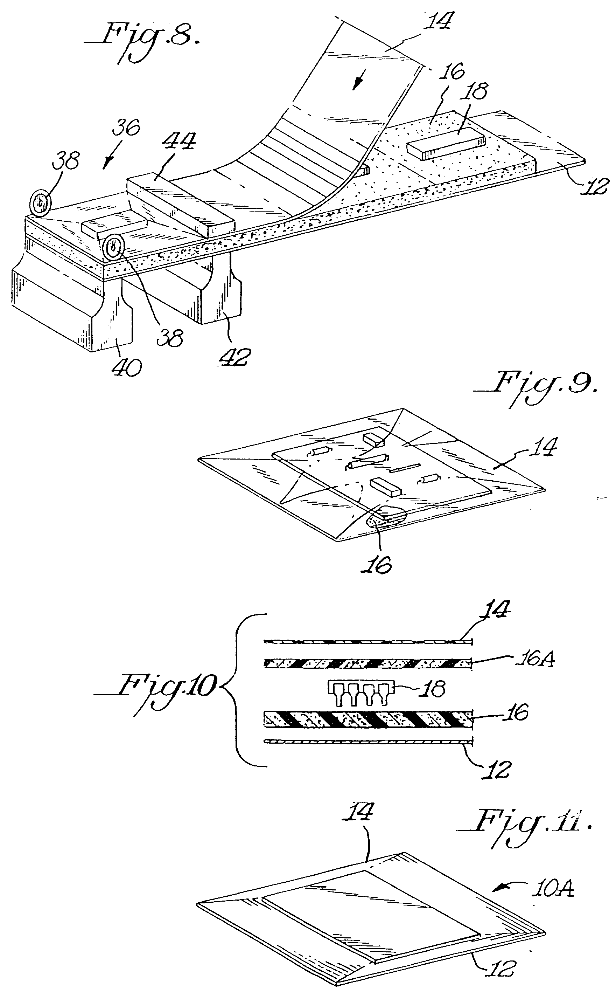

Figures 1-3 illustrate an electrostatic sensitive component package 10 in accordance with this invention. As shown therein the package 10 includes a lower layer 12 of metallized plastic such as a metallized polyester sheet and a similar upper layer 14. A layer of foam 16 is disposed between the upper and lower layers 12 and 14 with the electrostatic sensitive component 18 mounted against foam 16.

The invention may also be practiced by having the cushioning layer on the outside of the package formed by the two metallized plastic layers. Alternatively, the cushioning layer could be made conductive to replace one or both of the metallized plastic layers in making the Faraday cage, or to supplement the metallized plastic layers.

A significant feature of the present invention is that the peripheral edges of the layers 12, 14 and 16 are secured together by an ultrasonic seal 20 with an unsealed edge 21 which extends completely around the periphery of the package. Seal 20 isolates the component 18 and form a Faraday cage. This prevents electrostatic forces from entering the package and getting to the component by shielding completely around the component with conductive material. This is of particular concern under certain weather conditions. For example, in the winter where the package might be stored in heated areas with low humidity, there would be concern from tribo-electric effects. The Faraday cage effectively prevents electromagnetic forces such as from sonar, motors, radar, etc. from reaching the component. It is to be understood that the invention in its broad practice may be used for packaging any electrostatic sensitive part. In the preferred practice of the invention that part is an integrated circuit.

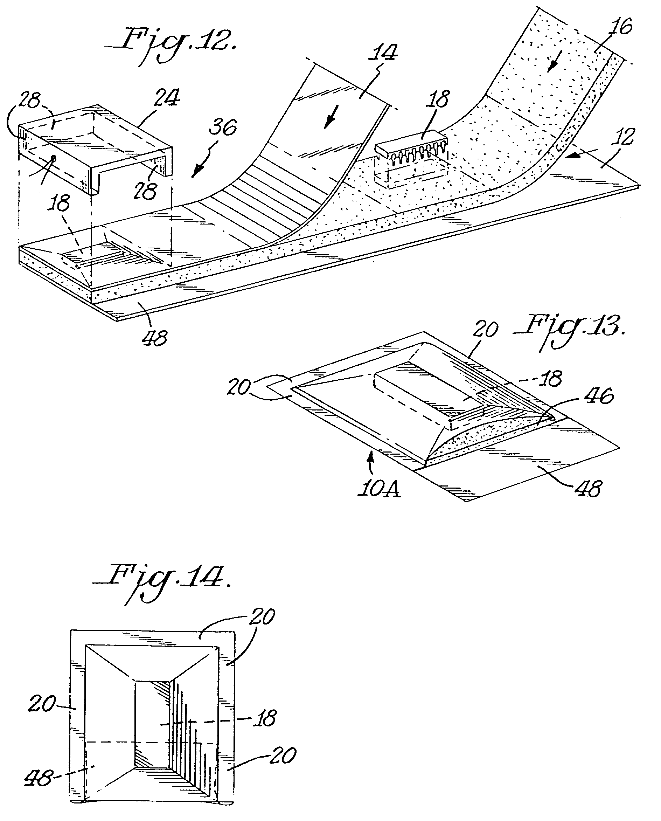

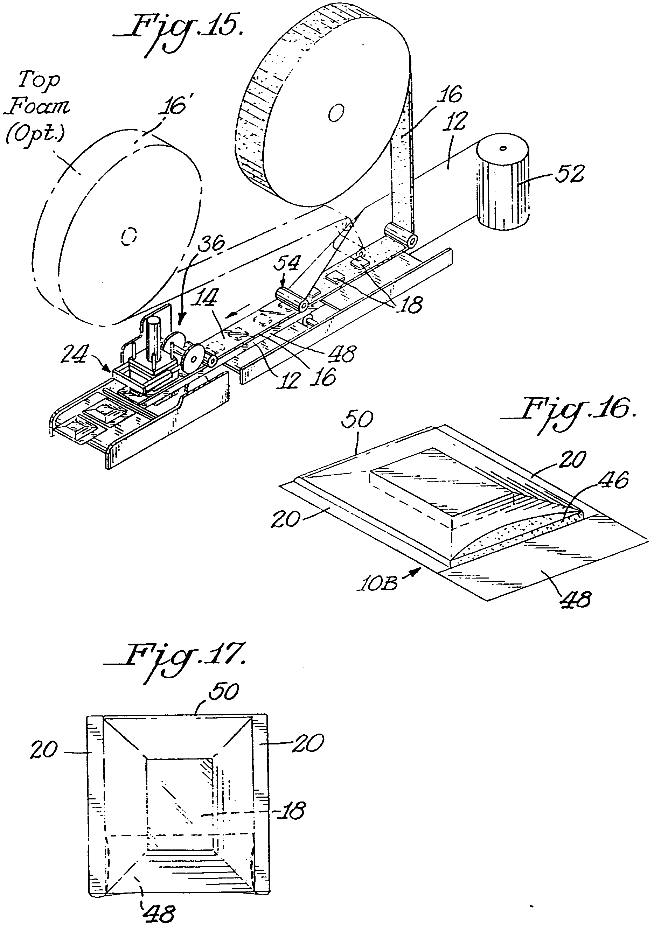

Figures 4-7 illustrate the manner of forming package 10 wherein the packages are formed in an automated manner. As shown therein the various layers and components would come from individual sources. Figure 7, for example, illustrates a web of metallized sheet 12 with a web of foam material 16 being fed to be superimposed over sheet 12. Figure 7 also illustrates a further web of metallized sheet 14 to be disposed over foam 16. Sheets 12,14 may be supplied from any suitable source such as rolls. Similarly, foam 16 may also be supplied in a roll form.

A series of components 18 would be placed centrally between the sides of foam 16 with the pins 22 extending downwardly for penetrating the foam 16. The components 18 would be spaced apart by a distance corresponding to the later-formed individual packages. Foam 16 could have the component 18 mounted thereon in the manner described in U.S. Patent No. 4,790,433. The invention eliminated the need for a primer and for adhesive. The right hand portion of Figure 7 thus illustrates three unlaminated webs being superimposed as they reach a sealing station where an ultrasonic sealing die 24 is located.

When the superimposed layers reach the ultrasonic sealing die 24 the speed of feed is coordinated with the downward movement of the sealing die so that the sealing die 24 is mounted centrally above component 18 as illustrated, for example, in Figures 5-6. Sealing die 24 moves downwardly from the position shown in Figure 5 to the position shown in Figure 6 to press the layers 12 and 14 and intermediate foam layer 16 together and form an ultrasonic seal 20.

As best illustrated in Figures 5-6 the sealing die 24 includes a closed peripheral seal forming edge 28 with a recess 30. Recess 30 is dimensioned to fit over the portion of the about-to-be formed package containing the component 18 with the component 18 being centrally located in the resultant package.

Figures 6 illustrates the formation of the seal 20 by the die 24 pressing downwardly to squeeze the layers of sheets 12,14 and foam 16 together and thereby form a domed extension 32 in the resultant package.

Any suitable known ultrasonic sealing die may be used in the practice of this invention. If desired, the ultrasonic sealing die could also sever the sealed layers along separating lines 26. Alternatively, the separation could take place subsequently by a suitable cutting instrument.

It is noted that the dome shape 32 in Figures 1-3 and 6 is shown in exaggerated form to illustrate the shape that might be taken if the component 18 essentially simply lies on the foam 16 without pressing into the foam. In actual practice the shape of the package would be more of a flat nature such as generally illsutrated in Figure 9.

The various materials used for forming package 10 may be of the same of those described in U.S. Patent No. 4,790,433. It is preferred that the layers 12,14 be made from a metallized polyester film and that the foam 16 which is an electrically conductive foam be made from relatively thick carbonized open cell polyurethane, having, for example, a thickness of from 1/16 to 1 inch.

It is to be understood that the invention may be practiced with numerous variations. Thus, for example, the support layer 16 need not be a foam material particularly where the component 18 does not include fragile extensions such as pins 22. In such case, all that is necessary is to provide some support for the component. Such support should be an anti-stat material which could be a foam, either open cell or closed cell. Alternatively, other anti-stat materials could be used such as bubble pack materials.

Figure 9 illustrates a preferred practice of this invention wherein at least the top layer 14 is made of a transparent material so that the components can be readily viewed and identified visually by looking through the transparent material. This avoids the need to label the packages so that the users would know what type of components are housed in the packages.

The invention may also be practiced by providing two layers of foam 16,16A as in Figure 10 where additional support is desired for the component 18. In this practice of the invention it is not necessary to form the top sheet of transparent material since the component would be concealed by the foam layer 16A. As noted, it is not necessary that the layers 16 and 16A be made of foam as long as the layers are made of an anti-stat material which provides sufficient support.

Figure 11 shows yet another alternative of this invention wherein the package 10A completely omits any support material and simply houses the component between the upper and lower layers 12,14. Package 10A would be used where the components have sufficient rigidity that a support is not necessary.

Figure 8 shows an alternative ultrasonic die system for forming packages in accordance with this invention. As shown therein the various layers 12, 14 and 16 would be conveyed to the ultrasonic sealing station 36. In place of the ultrasonic die 24 of Figure 7, the sealing station of Figure 8 includes a pair of rotary anvils 38 mounted along the machine direction spaced from each other a distance corresponding to one of the dimensions of the finished package. A pair of stationary horns 40,42 is mounted below the various layers in the cross machine direction. Horn 40 is disposed immediately below the rotary anvils 38, while horn 42 is disposed immediately below the cross machine direction anvil 44. Anvils 38,38 and 44 are mounted above the layers. In operation, the various anvils and horns would remain fixed with respect to the longitudinal or machine direction, although there would be relative vertical movement between the anvils and horns such as by a raising and lowering of the anvils to permit sufficient clearance for the layers to pass through the anvils and their respective horns. The anvils would then be lowered into contact with the layers. This movement of the anvils is coordinated with the speed of the layers in the machine direction to press downwardly upon the layers. Anvil 44 creates an ultrasonically sealed edge in the cross direction and also severes the layers transversely or in the cross direction as the layers move downstream. During this movement the rotary anvils 38 create parallel longitudinal ultrasonically sealed edges so that the resultant package has its sealed completely around its periphery.

Various types of components could be housed in the various packages. Figure 9, for example, illustrates the components to include resistors, pc boards and wires as well as any other suitable components.

The package 10 of Figure 3 is ultrasonically sealed around its entire periphery. Figures 13-14 illustrate a package 10A which is in the form of a pouch having an open end 46 with a flap 48 extending from the open end as clearly shown in Figure 13. Flap 48 can be tucked into the open end to close the package 10A as shown in Figure 14.

Figure 12 illustrates the automated assembly for forming package 10A. The assembly is of the same general type of structure as in Figure 7. As shown in Figure 12 the lower layer 12 is fed toward the sealing station 36. Foam material 16 is disposed on lower layer 12. The electrical components 18 would be sequentially mounted on foam layer 16 and then the upper layer 14 would be superimposed over the components and foam layer in the manner described with respect to Figure 7. In the embodiment of Figure 12, however, lower layer 12 is made wider than the foam layer 16 and the upper layer 14 so that an excess portion of material would project beyond the superimposed layers 14, 16 which would in turn form the flap 48 of each later formed package. The die 24 would have three seal forming edges 28 with an open fourth side. Thus, when die 24 presses against the superimposed layers, an ultrasonic seal 20 is formed along three edges of the resulting package. As shown in Figures 13 and 14 the remaining side 46 is open as previously described.

The individual packages may be separated from each other during the sealing process by a cutter located at the upstream side sealing edge 28 which would cut the flap 48 while the remaining edges of the package are cut by the seal forming edges 28. Alternatively, the severing of the component into individual packages may take place downstream from the sealing station 36.

Figures 15-17 illustrate a further variation of this invention wherein a pouch type package 10B is formed by folding the lower layer 12 upon itself at the edge 50 remote from the open end 46 of the package. The package would be closed by tucking in the flap 48 as shown in Figure 17.

Figure 15 illustrates the automated assembly for forming packages 10B. As shown therein the layer 12 is supplied as a film on roller 52 which is vertically mounted with respect to the orientation of the final package. Layer 12 is bent 90° as it enters the assembly whereby the lower horizontal portion of film forms the bottom layer of the ultimately resulting package. A foam layer 16 is superimposed over the bent base layer 12 and the components 18 are mounted as previously described. The upper layer is then formed by again bending the remaining portion of layer 12 so that layer 12 is folded upon itself at bending station 54. The upper portion of layer 12 is of a width which corresponds to the width of foam 16, while the lower portion of layer 12 extends a greater portion to create the flap material 48.

The sealing station 36B in Figure 15 would include a die 24 having sealing edges only along the opposite side walls to form the two ultrasonic sealed edges 20 illustrated in Figures 16 and 17. The packages would be separated from each other in the same manner described with respect to Figures 12-14.

Although Figures 12-14 and 15-17 describe forming the flap 48 from the lower layer 12, the invention may also be practiced where it is the upper layer 14 which is wider. Thus, the flap would be an extension of the upper layer.

It is to be understood that various features described with respect to any particular embodiment of this invention may be incorporated in other embodiments thereof.

The present invention is particularly advantageous in that it provides an assembly for automatically packaging electrostatic sensitive parts such as integrated circuits. This is particularly advantageous when compared to prior practices which involve hand packaging integrated circuits. A significant feature of the present invention is the securing of the various layers together by means of an ultrasonic seal which effectively forms a Faraday cage around the electrostatic sensitive part.

It should be noted that the objects and advantages of the invention may be attained by means of any compatible combination(s) particularly pointed out in the items of the following summary of the invention and the appended claims.
1. In an electrostatic sensitive component package including a lower layer of conductive material, an upper layer of conductive material, and an electrostatic sensitive component disposed between said layers, the improvement being in that said layers of conductive material are secured together by an ultrasonic seal, said ultrasonic seal being a peripheral seal at least partially around said component, and said peripheral seal forming a Faraday cage around said component to prevent electrostatic forces from reaching said component to thereby form an anti-stat package for said component.
2. The package **wherein preferably** said ultrasonic seal is a completely closed peripheral seal extending completely around said component.
3. The package **wherein preferably** said conductive material is metallized plastic.
4. The package **preferably** including a lower anti-stat support member between said upper layer and said lower layer, and said electrostatic sensitive component being disposed against said lower support member with said component being remote from said lower layer.
5. The package **wherein preferably** said support member is foam.
6. The package **wherein preferably** said foam is a carbonized open cell polyurethane foam, said electrostatic sensitive component being an integrated circuit, said integrated circuit having pins extending in one direction thereof, said pins being imbedded into said foam, and said metallized plastic being metallized polyester film.
7. The package **preferably** including an upper anti-stat support member against between said upper layer and said electrostatic sensitive component.
8. The package **wherein preferably** at least a portion of said upper layer is transparent, and said electrostatic sensitive component being visible through said upper layer.
9. The package **preferably** including a lower anti-stat support member between said upper layer and said lower layer, and said electrostatic sensitive component being disposed against said support member with said component being remote from said lower layer.
10. The package **preferably** including an upper anti-stat support member against between said upper layer and said electrostatic sensitive component.
11. The package **wherein preferably** at least a portion of said upper layer is transparent, and said electrostatic sensitive component being visible through said upper layer.
12. The package **wherein preferably** said upper layer is transparent, and said electrostatic sensitive component being visible through said upper layer.
13. The package **wherein preferably** said ultrasonic seal is around at least two edges of said package to create a pouch, and one edge of said pouch being openable and closable by a flap at said one edge to enclose the component in said pouch.
14. The package **preferably** including a lower anti-stat support member is between said upper layer and said lower layer, and said electrostatic sensitive component being disposed against said lower support member with said component being remote from said lower layer.
15. The package **wherein preferably** said support member is a carbonized open cell polyurethane foam, said electrostatic sensitive component being an integrated circuit having pins extending in one direction thereof, said pins being imbedded into said foam, and said conductive material being metallized polyester film.
16. The package **preferably** including an upper anti-stat support member against between said upper layer and said electrostatic sensitive component.
17. The package **wherein preferably** said upper layer is transparent, and said electrostatic sensitive component being visible through said upper layer.
18. The package **wherein preferably** said pouch is ultrasonically sealed along three edges thereof.
19. The package **wherein preferably** said lower layer and said upper layer are portions of a single film folded upon itself to create said lower layer and said upper layer, and said pouch being sealed along two edges thereof.
20. The package **preferably** including a cushioning layer disposed against one of said upper layer and said lower layer, and said conductive material being metallized plastic.
21. The package **wherein preferably** said cushioning layer is foam.
22. The package **wherein preferably** said foam layer is between said upper layer and said lower layer.
23. The package **wherein preferably** said cushioning layer is a bubble pack material.
24. The package **wherein preferably** said cushioning layer is disposed outwardly of both of said upper layer and said lower layer.
25. An assembly for the automated packaging of electrostatic sensitive components comprising a first feed station for feeding a lower layer of conductive material to a sealing station, means for feeding electrostatic sensitive components mounted in spaced relationship from each other over the lower layer, a second feed station feeding a second conductive layer to the sealing station with the second conductive layers being superimposed over the electrostatic sensitive components and the lower layer at the sealing station, an ultrasonic sealing assembly at the sealing station, said ultrasonic sealing assembly having a sealing surface means dimensioned to fit around each successive electrostatic sensitive component with the sealing edge spaced between successive components for ultrasonically sealing at least two spaced edges of the resulting package, and means for cutting the layers into individual packages after the ultrasonic seal has been formed.
26. The assembly **wherein preferably** the conductive layers are metallized plastic, and including an intermediate feed station feeding a layer of anti-stat support material superimposed over the first layer at the sealing station with the components mounted on the support material.
27. The assembly **preferably** including a further intermediate feed station feeding a further layer of anti-stat support material above the components and superimposed over the first layer at the sealing station.
28. The assembly **wherein preferably** the component is an integrated circuit, the layers of metallized plastic being metallized polyester film, and the support material being a carbonized open cell polyurethane foam.
29. The assembly **wherein preferably** the sealing surface means forms an ultrasonic seal along at least two spaced edges of the resulting package with an intermediate edge being unsealed and open.
30. The assembly **wherein preferably** said ultrasonic sealing assembly includes three sealed forming edges for ultrasonically sealing three edges of the resulting package.
31. The assembly **wherein preferably** one of the layers is of greater width than the other of the layers whereby a portion of the one layer extends outwardly beyond the other layer to form a flap for the resulting package at its open edge.
32. The assembly **wherein preferably** said first feed station and said second feed station are the same feed station for feeding a sheet of metallized plastic film, said assembly including a folding station for folding the sheet of metallized plastic film upon itself to create the lower layer and the upper layer, and one of the layers being of greater width than the other of the layers to form a flap for the resulting package at its open edge.
33. The assembly **wherein preferably** the ultrasonic sealing assembly includes a closed continuous seal forming edge to form a peripheral ultrasonic seal completely around the resulting package.
34. A method of forming an electrostatic sensitive component package comprising the steps of feeding a lower layer of conductive material to a sealing station, feeding a plurality of spaced electrostatic sensitive components over the lower layer, feeding an upper conductive layer to the sealing station with the upper layer superimposed above the spaced component and the lower layer at the sealing station, ultrasonically sealing the layers together at the sealing station to form a laminate, repeating the sealing step for successively spaced components, and severing the laminates formed from the sealing step to form individual packages having at least two spaced edges ultrasonically sealed.
35. The method **wherein preferably** the upper and lower layers are metallized plastic, and including feeding a layer of anti-stat support material above the lower layer and superimposed over the lower layer at the sealing station, and mounting the components against the support material.
36. The method **wherein preferably** the component is an integrated circuit, the layers of metallized plastic being metallized polyester film, and the support material being a carbonized open cell polyurethane foam.
37. The method **wherein preferably** an ultrasonic seal is formed completely peripherally around each individual package.
38. The method **wherein preferably** the ultrasonic seal is formed along at least two spaced edges of the package with an intermediate edge being unsealed and open.
39. The method **wherein preferably** an ultrasonic seal is formed around three edges of the package with the fourth edge being open, one of the layers being of greater width than the other of the layers to form a flap at the open edge of the package, and the flap permitting the package to be selectively opened and closed.
40. The method **wherein preferably** the lower layer and the upper layer are formed from a single sheet of film which is folded upon itself to create the lower layer and the upper layer, one of the layers extending laterally beyond the other layer so that a flap is formed by the portion of the one layer which is not superimposed by the other layer, forming ultrasonically sealed edges along the two edges between the folded edge and the open edge of the package, and the flap selectively opening and closing the package.

## Claims

1. In an electrostatic sensitive component package including a lower layer of conductive material, an upper layer of conductive material, and an electrostatic sensitive component disposed between said layers, the improvement being in that said layers of conductive material are secured together by an ultrasonic seal, said ultrasonic seal being a peripheral seal at least partially around said component, and said peripheral seal forming a Faraday cage around said component to prevent electrostatic forces from reaching said component to thereby form an anti-stat package for said component.

2. The package of Claim 1 wherein said ultrasonic seal is a completely closed peripheral seal extending completely around said component.

3. The package of Claim 1 wherein said support member is a carbonized open cell polyurethane foam, said electrostatic sensitive component being an integrated circuit having pins extending in one direction thereof, said pins being imbedded into said foam, and said conductive material being metallized polyester film.

4. The package of Claim 1 including a cushioning layer disposed against one of said upper layer and said lower layer, and said conductive material being metallized plastic.

5. An assembly for the automated packaging of electrostatic sensitive components comprising a first feed station for feeding a lower layer of conductive material to a sealing station, means for feeding electrostatic sensitive components mounted in spaced relationship from each other over the lower layer, a second feed station feeding a second conductive layer to the sealing station with the second conductive layers being superimposed over the electrostatic sensitive components and the lower layer at the sealing station, an ultrasonic sealing assembly at the sealing station, said ultrasonic sealing assembly having a sealing surface means dimensioned to fit around each successive electrostatic sensitive component with the sealing edge spaced between successive components for ultrasonically sealing at least two spaced edges of the resulting package, and means for cutting the layers into individual packages after the ultrasonic seal has been formed.

6. The assembly of Claim 5 wherein the sealing surface means forms an ultrasonic seal along at least two spaced edges of the resulting package with an intermediate edge being unsealed and open.

7. The assembly of Claim 5 wherein the ultrasonic sealing assembly includes a closed continuous seal forming edge to form a peripheral ultrasonic seal completely around the resulting package.

8. A method of forming an electrostatic sensitive component package comprising the steps of feeding a lower layer of conductive material to a sealing station, feeding a plurality of spaced electrostatic sensitive components over the lower layer, feeding an upper conductive layer to the sealing station with the upper layer superimposed above the spaced component and the lower layer at the sealing station, ultrasonically sealing the layers together at the sealing station to form a laminate, repeating the sealing step for successively spaced components, and severing the laminates formed from the sealing step to form individual packages having at least two spaced edges ultrasonically sealed.

9. An electrostatic sensitive component package including a lower layer of conductive material, an upper layer of conductive material, and an electrostatic sensitive component disposed between said layers, wherein said layers of conductive material are secured together by an ultrasonic seal.
